(19)

Europäisches
Patentamt
European
Patent Office
Office européen
des brevets

(11) **EP 4 632 483 A1**

(12) **EUROPEAN PATENT APPLICATION**

(43) Date of publication:
**15.10.2025 Bulletin 2025/42**

(21) Application number: **24169424.9**

(22) Date of filing: **10.04.2024**

(51) International Patent Classification (IPC):
**G03F 7/00** (2006.01)    **H04N 23/54** (2023.01)

(52) Cooperative Patent Classification (CPC):
**G03F 7/706845; G03F 7/706851; H04N 23/54**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
- **SCHOLZ, Sandy, Claudia**
  **5500 AH Veldhoven (NL)**
- **NIENHUYS, Han-Kwang**
  **5500 AH Veldhoven (NL)**
- **TAO, Yin**
  **5500 AH Veldhoven (NL)**
- **EDWARD, Stephen**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **FORMING A REFERENCE IRRADIANCE PATTERN ON A DETECTOR**

(57)    Described herein is a method comprising: illuminating an optical element with a reference illumination, wherein the optical element is configured to produce, from the reference illumination, a plurality of reference irradiance beams incident on a detector to form a reference irradiance pattern on the detector, the reference irradiance pattern comprising a plurality of reference irradiance spots; and determining a position related parameter of the detector relative to the optical element based on the plurality of reference irradiance spots. A computer program product is also described. Additionally described herein is an apparatus comprising a processor configured to determine a position related parameter of a detector relative to an optical element based on a plurality of reference irradiance spots.

Fig. 13

EP 4 632 483 A1

## Description

### FIELD

The present invention relates to a method and an apparatus for forming a reference irradiance pattern on a detector, e.g. a detector of a metrology apparatus, to enable accurate determination of a position related parameter of the detector.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low $k_1$.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating/target medium, thereby generating an emitted radiation, optionally a high harmonic generation (HHG) comprising high frequency radiation.

A metrology apparatus may comprise a detector, also referred to as an image sensor. In order to perform metrology (e.g. using broadband soft X-ray radiation), it is necessary to determine the position of the detector relative to the metrology subject (e.g. a substrate such as a wafer).

## SUMMARY

The present disclosure provides methods and apparatuses that may lead to improvements in alignment and/or calibration of a metrology apparatus. In particular, determining the position of the detector by fitting 6 degrees of freedom (DoF) (or even 12 DoF in the case of a dual-detector arrangement, or 18 DoF in the case of a triple-detector arrangement) can be very difficult due to the level of accuracy required.

There is therefore a need for a calibration that can preferably be achieved to an accuracy of less than a detector pixel size.

According to a first aspect of the present disclosure, there is provided a method comprising: illuminating an optical element with a reference illumination, wherein the optical element is configured to produce, from the reference illumination, a plurality of reference irradiance beams incident on a detector to form a reference irradiance pattern on the detector, the reference irradiance pattern comprising a plurality of reference irradiance spots; and determining a position related parameter of the detector relative to the optical element based on the plurality of reference irradiance spots.

According to a second aspect of the present disclosure, there is provided a method comprising: illuminating an optical element with a reference illumination, the optical element comprising a computer generated hologram, wherein the optical element is configured to produce, from the reference illumination, a plurality of reference irradiance beams incident on a detector to form a reference irradiance pattern on the detector, the reference irradiance pattern comprising a plurality of reference irradiance spots.

According to a third aspect of the present disclosure, there is provided a method comprising: illuminating an optical element with a reference illumination, the optical element comprising a photonic integrated circuit configured to produce, from the reference illumination, a plurality of reference irradiance beams incident on a detector to form a reference irradiance pattern on the detector, the reference irradiance pattern comprising a plurality of reference irradiance spots; and determining a position related parameter of the detector relative to the optical element based on the plurality of reference irradiance spots.

According to a fourth aspect of the present disclosure, there is provided a method comprising: illuminating an optical element with a reference illumination, wherein the optical element is configured to produce, from the reference illumination, a plurality of reference irradiance beams incident on a detector to form a reference irradiance pattern on the detector, the reference irradiance pattern comprising a plurality of reference irradiance spots; aligning the reference illumination with respect to the optical element based on a reflection of the reference illumination by the optical element; and determining a position related parameter of the detector relative to the optical element based on the plurality of reference irradiance spots.

According to a fifth aspect of the present disclosure, there is provided a method comprising: illuminating an optical element with a reference illumination, wherein the optical element is configured to produce, from the reference illumination, a plurality of reference irradiance beams incident on a detector to form a reference irradiance pattern on the detector, at least one of the reference irradiance beams having an astigmatic profile, the reference irradiance pattern comprising a plurality of reference irradiance spots; and determining a position related parameter of the detector relative to the optical element based on a shape of the irradiance spot formed by the reference irradiance beam having the astigmatic profile.

According to a sixth aspect of the present disclosure, there is provided a method comprising: illuminating an optical element with a reference illumination, wherein the optical element is configured to produce, from the reference illumination, a plurality of reference irradiance beams incident on a detector to form a reference irradiance pattern on the detector, two or more of the reference irradiance beams having different foci, the reference irradiance pattern comprising a plurality of reference irradiance spots; and determining a position related parameter of the detector relative to the optical element based on sizes of the reference irradiance spots formed by the reference irradiance beams having different foci.

According to a seventh aspect of the present disclosure, there is provided an apparatus comprising: a reference illumination source configured to illuminate an optical element with a reference illumination; a detector; and a processor; wherein the optical element is configured to produce, from the reference illumination, a plurality of reference irradiance beams incident on the detector to form a reference irradiance pattern on the detector, the reference irradiance pattern comprising a plurality of reference irradiance spots; and wherein the processor is configured to determine a position related parameter of the detector relative to the optical element based on the plurality of reference irradiance spots.

According to an eighth aspect of the present disclosure, there is provided an apparatus comprising: a reference illumination source configured to illuminate an optical element with a reference illumination, the optical element comprising a computer generated hologram; and detector; and a processor; wherein the optical element is configured to produce, from the reference illumination, a plurality of reference irradiance beams incident on the detector to form a reference irradiance pattern on the detector, the reference irradiance pattern comprising a plurality of reference irradiance spots; and wherein the processor is configured to determine a position related parameter of the detector relative to the optical element based on the plurality of reference irradiance spots.

According to a ninth aspect of the present disclosure, there is provided an apparatus comprising: a reference illumination source configured to illuminate an optical element with a reference illumination, the optical element comprising a photonic integrated circuit; a detector; and a processor; wherein the optical element is configured to produce, from the reference illumination, a plurality of reference irradiance beams incident on the detector to form a reference irradiance pattern on the detector, the reference irradiance pattern comprising a plurality of reference irradiance spots; and wherein the processor is configured to determine a position related parameter of the detector relative to the optical element based on the plurality of reference irradiance spots.

According to a tenth aspect of the present disclosure, there is provided an apparatus comprising: a reference illumination source configured to illuminate an optical element with a reference illumination, wherein the reference illumination source is configured to be aligned with respect to the optical element based on a reflection of the reference illumination by the optical element; a detector; and a processor; wherein the optical element is configured to produce, from the reference illumination, a plurality of reference irradiance beams incident on the detector to form a reference irradiance pattern on the detector, the reference irradiance pattern comprising a plurality of reference irradiance spots; and determining a position related parameter of the detector relative to the optical element based on the plurality of reference irradiance spots.

According to an eleventh aspect of the present disclosure, there is provided an apparatus comprising: a reference illumination source configured to illuminate an optical element with a reference illumination; a detector; and a processor; wherein the optical element is configured to produce, from the reference illumination, a plurality of reference irradiance beams incident on the detector to form a reference irradiance pattern on the detector, at least one of the reference irradiance beams having an astigmatic profile, the reference irradiance pattern comprising a plurality of reference irradiance spots; and wherein the processor is configured to determine a position related parameter of the detector relative to the optical element based on a shape of the irradiance spot formed by the reference irradiance beam having the astigmatic profile.

According to a twelfth aspect of the present disclosure, there is provided an apparatus comprising: a reference illumination source configured to illuminate an optical element with a reference illumination; a detector; and a processor; wherein the optical element is configured to produce, from the reference illumination, a plurality of reference irradiance beams incident on the detector to form a reference irradiance pattern on the detector, two or more of the reference irradiance beams having different foci, the reference irradiance pattern comprising a plurality of reference irradiance spots; and wherein the processor is configured to determine a position related parameter of the detector relative to the optical element based on sizes of the reference irradiance spots formed by the reference irradiance beams having different foci.

The following examples may correspond to embodiments of one or more of the aspects described herein.

In some examples, the position related parameter of the detector relative to the optical element is determined based on positions of the reference irradiance spots on the detector.

The position related parameter may be fitted, e.g. to positions, shapes, and/or sizes of the reference irradiance spots on the detector.

In some examples, the reference irradiance pattern comprises at least three reference irradiance spots. For example, three reference irradiance spots arranged in a triangle (preferably not an equilateral triangle). In some examples, the reference irradiance pattern comprises at least four reference irradiance spots. Preferably, the at least four reference irradiance spots are not arranged in a square. Such an irregular pattern of at least four reference irradiance spots may be particularly suited to determining the position related parameter in cases where the detector surface is curved (e.g. due to stress).

Preferably, the reference illumination comprises monochromatic radiation having a known wavelength (e.g. a laser beam). For example, the reference illumination source may comprise a laser. In an example, the reference illumination has a wavelength of 633 nm (e.g. the reference illumination source may comprise a HeNe laser). However, other wavelengths, for example in the infrared (IR), near-infrared (NIR), visible, near-ultraviolet (NUV), or ultraviolet (UV), may also be suitable.

In some examples, the optical element comprises a phase mask.

In some examples, the optical element comprises an amplitude mask.

In some examples, the optical element comprises a grating (e.g. a diffraction grating).

In some examples, the optical element comprises a spatial light modulator.

In some examples, the optical element comprises a hologram.

In some examples, the optical element comprises a computer generated hologram (CGH). Advantageously, a CGH may enable the optical element to be designed such that any desired properties are imparted to the reference irradiance beams, including their focus points (e.g. on the plane of the detector), the shape and/or size of the reference irradiance spots, the shape of the reference irradiance pattern, and/or the number of reference irradiance beams/spots in the reference irradiance pattern.

In some examples, the optical element comprises a pinhole mask.

In some examples, the optical element comprises a plurality of curved mirrors, for example parabolic mirrors, ellipsoidal mirrors, and/or spherical mirrors. The plurality of curved mirrors may comprise concave and/or convex mirrors. In some examples, any aberrations introduced to the reference irradiance beams by the curved mirrors may be corrected by subsequent data processing.

In some examples, at least a portion of the optical element is reflective to the reference illumination. For example, the optical element may be configured to reflect the reference illumination (in the form of the reference irradiance pattern) towards the detector.

In some examples, at least a portion of the optical element is transmissive to the reference illumination. For example, the optical element may be illuminated from below (i.e. from an opposite side of the optical element with respect to the detector). Such an arrangement may advantageously lead to a more compact metrology apparatus. For example, when the detector is a detector of an apparatus for measuring a substrate, the illumination source may be provided to the optical element through a substrate support, or substrate stage, where the optical element may be located on the substrate support, leading to a modular design.

In some examples, the reference illumination (or the reference illumination source) may be aligned (or configured to be aligned) with respect to the optical element based on a reflection of the reference illumination by the optical element. For example, the reference illumination could be aligned based on backscattered radiation propagating back to the illumination source.

In some examples, the optical element may comprise an alignment guide. The alignment guide may comprise a portion of the optical element that is reflective to the reference illumination. For example, the optical element may comprise a transmissive portion and a reflective portion (e.g. surrounding the transmissive portion).

Reference illumination that is reflected by the optical element and used for alignment of the reference illumination may be detected by one or more alignment detectors. For example, one or more alignment detectors may be integrated with a substrate support.

In some examples, the optical element comprises an integrated optical device such as a photonic integrated circuit (PIC).

In some examples, the optical element may be illuminated with the reference illumination via an optical fiber.

Using a PIC, and/or an optical fiber, may advantageously reduce the sensitivity of the reference irradiance pattern to beam pointing and/or beam profile quality of the reference illumination.

In addition, an optical element comprising a PIC may be easier to manufacture within the required tolerances to generate some reference irradiance patterns, in comparison to some other kinds of optical elements.

In some examples, the reference irradiance pattern comprises a coarse pattern and a fine pattern. For example, the fine pattern may comprise reference irradiance spots that are more closely spaced than the reference irradiance spots making up the coarse pattern. The coarse pattern and the fine pattern may both be produced by a same optical element, or alternatively the coarse pattern may be produced by a first optical element, and the fine pattern may be produced by a second optical element. The second optical element may be illuminated with the same reference illumination as the first optical element, or may be illuminated by a second reference illumination (i.e. the apparatus may comprise a second reference illumination source configured to illuminate the second optical element with the second reference illumination).

Advantageously, the coarse pattern may be used to obtain a coarse estimate of the position related parameter of the detector, while the fine pattern may be used to obtain a more precise estimate.

In some examples, the optical element is configured such that the reference irradiance pattern comprises 10s, 100s, or even 1000s of reference irradiance spots.

Preferably, the optical element is configured such that the size of a reference irradiance spot formed by a focused reference irradiance beam is smaller than a pixel size of the detector (e.g. smaller than 10 $\mu$m, smaller than 15 $\mu$m, smaller than 20 $\mu$m, or smaller than 25 $\mu$m in some examples).

As described herein, the detector may be a detector of a metrology apparatus (e.g. for measuring a substrate, e.g. a wafer).

The position related parameter of the detector may be determined relative to a substrate to be measured by the metrology apparatus based on: the position related parameter of the detector relative to the optical element; and a position of the optical element relative to the substrate.

An apparatus according to the present disclosure may comprise the optical element described herein.

In some examples, the optical element may be disposed, or located, on a substrate to be measured by the metrology apparatus.

In some examples, the optical element is configured such that at least one of the reference irradiance beams has an astigmatic profile. The position related parameter of the detector relative to the optical element may be determined based on a shape of the irradiance spot formed by the at least one reference irradiance beam having the astigmatic profile. For example, the reference irradiance pattern may be formed by a combination of reference irradiance beams respectively having astigmatic profiles and non-astigmatic profiles. The shape of the reference irradiance spot formed by the reference irradiance beam having the astigmatic profile would depend on the position of the detector, i.e. where the reference irradiance beam intersects the plane of the detector. For example, a beam having an astigmatic profile may be configured such that a spot formed on the detector by that beam is circular when the detector is in an expected position, but non-circular when the detector is not in the expected position. Alternatively or in addition, a beam (e.g. another beam) having an astigmatic profile may be configured such that a spot (e.g. another spot) formed by that beam is non-circular when the detector is in the expected position. In some examples, the use of one or more reference irradiance beams having an astigmatic profile may enable the determination of a positive or negative offset of the detector position from the expected position, or from a nominal, or design, position, because the shape of the formed spot(s) will vary between positive and negative offsets.

In some examples, the optical element is configured such that two or more of the reference irradiance beams have different foci. For example, the size of the reference irradiance spots formed by the reference irradiance beams may depend on the position of the detector. The position related parameter of the detector relative to the optical element may therefore be determined based on sizes of the reference irradiance spots formed by the reference irradiance beams having different foci.

In some examples, the optical element may be configured such that the reference irradiance beams comprise a combination of at least some beams having astigmatic profiles, and/or different foci.

In some examples, the reference irradiance pattern comprises a speckle pattern.

In some examples, positions of the reference irradiance spots may be mapped to pupil coordinates of the reference irradiance beams.

In some examples, part of the reference irradiance pattern, and/or a second reference irradiance pattern, may be formed on a second detector by the plurality of reference irradiance beams, or by a second plurality of reference irradiance beams (e.g. where the second plurality of reference irradiance beams may be formed by a second optical element). The (part of the) reference irradiance pattern formed on the second detector may comprise a second plurality of reference irradiance spots. A position related parameter r of the second detector relative to the optical element may be determined based on the second plurality of reference irradiance spots, e.g. based on the positions, shapes, and/or sizes of the second plurality of reference irradiance spots as described herein with respect to the first detector.

A position related parameter of a detector according to the present disclosure may comprise e.g. a coordinate in three-dimensional (3D) space (e.g. x, y, z), and/or a rotation parameter. That is, the position related parameter may define the 6 degrees of freedom (DoF) of a given detector (3 translation DoF, 3 rotation DoF). The position related parameter(s) may define a plane of the detector (e.g. at which the reference irradiance beams intersect with the detector and are incident on pixels of the detector). The position of a detector may be defined relative to something else, e.g. the optical element and/or a substrate, or wafer, to be measured by an apparatus comprising the detector. There may exist an expected, or nominal, position (or set of position related parameters) of a detector (also referred to as a design position), and the methods and apparatuses descried herein may enable determination of a deviation of the position of the detector(s) from the expected position.

As described herein, the methods and apparatuses according to the present disclosure may be employed in metrology, e.g. to measure properties of substrates as described herein (e.g. the apparatus may be a metrology apparatus or inspection apparatus as described herein). Radiation that is used for the purposes of measuring substrates may be referred to as a measurement illumination, and may be different (e.g. provided by a different source, such as a measurement illumination source) from the reference illumination. For example, the measurement illumination may be broadband illumination and may include radiation in the hard X-ray (HXR), soft X-ray (SXR), extreme ultraviolet (EUV), visible to near-infrared (IR) and/or IR wavelength range.

The measurement illumination and the detector(s) may be used to obtain calibration data (e.g. with respect to wavelength and/or intensity). For example, the measurement illumination may be directed onto the detector in the form of a diffraction pattern. The diffraction pattern may be produced by a fiducial target, which is illuminated with the measurement illumination. The fiducial target may be different, and/or separate, from the optical element described herein. The fiducial target may be configured to diffract the measurement illumination such that a diffraction pattern is incident on the detector. A position related parameter of the fiducial target relative to the detector may be determined. A position of the fiducial target relative to the optical element may be determined. The measurement illumination may comprise a plurality of spectral peaks. Wavelengths of the spectral peaks may be determined from the diffraction pattern incident on the detector.

The measurement illumination (source) and/or the fiducial target may be arranged such that the diffraction pattern is substantially in focus on the detector for the purposes of obtaining the calibration data. In some examples, a mirror (e.g. a toroid mirror) may be employed when performing measurement of a substrate (i.e. during metrology). The mirror may be rotated to direct the measurement illumination towards the fiducial target when the calibration data is to be obtained.

An illumination monitoring sensor (e.g. an array sensor) may be employed to monitor the measurement illumination during metrology. For example, during metrology, the mirror (e.g. toroid mirror) may be aligned so that the measurement illumination is directed through a transmissive diffraction grating so that a portion of the measurement illumination is diffracted and incident on the illumination monitoring sensor to monitor the spectral and/or intensity characteristics of the measurement illumination. For the calibration, as described above, the mirror may be rotated such that the measurement illumination passes by the transmissive diffraction grating and/or the illumination monitoring sensor.

The methods and apparatuses described herein may include obtaining a calibration for the illumination monitoring sensor.

For example, a wavelength calibration for the illumination monitoring sensor may be obtained using the determined wavelengths of the spectral peaks.

In some examples, an intensity spectrum for the measurement illumination may also be obtained (e.g. based on the spectrum of the measurement illumination incident on the detector). The intensity spectrum may be determined based additionally on a diffraction efficiency spectrum of the fiducial target.

An intensity calibration for the illumination monitoring sensor may be obtained using the determined intensity spectrum.

In some examples, the fiducial target comprises a diffraction grating having a variable line spacing, or variable line density (e.g. a grating or mask having curved lines with variable pitch). Advantageously, a variable line spacing may result in the wavelength components of the diffracted measurement illumination (i.e. the line foci) being straight where they would otherwise be curved lines. This may result in improved accuracy for the calibration measurements described herein.

Also described herein is a computer program product comprising instructions which, when the program is executed by a computer (in particular a processor of the computer), cause the computer to carry out any of the methods described herein.

## BRIEF DESCRIPTION OF THE DRAWINGS

Embodiments will now be described, by way of example only, with reference to the accompanying schematic drawings, in which:

- Figure 1 depicts a schematic overview of a lithographic system comprising a lithographic apparatus and a radiation source;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts at least part of an apparatus for determining a position related parameter of a detector according to the present disclosure;
- Figure 9 depicts at least part of an apparatus according to the present disclosure, wherein an optical element comprises a periodic grating;
- Figure 10 depicts at least part of an apparatus according to the present disclosure, wherein an optical element is at least partially transmissive to reference illumination;
- Figure 11 depicts an example of at least part of an apparatus according to the present disclosure, wherein an optical element comprises an alignment guide;
- Figure 12 depicts an example of at least part of an apparatus according to the present disclosure, wherein reference illumination may be aligned with an optical element based on reference illumination reflected by the optical element;
- Figure 13 depicts an example of at least part of an apparatus according to the present disclosure, wherein reference illumination is coupled into an optical element via an optical fiber;
- Figure 14 depicts an example of at least part of an apparatus according to the present disclosure comprising two detectors;
- Figure 15A depicts a schematic representation of a plurality of point sources that may be produced by an optical element;

- Figure 15B depicts an example of a reference irradiance pattern formed by the point sources of Figure 15A;

- Figure 16 schematically illustrates an example of at least part of an apparatus according to the present disclosure, wherein two overlapping reference irradiance patterns are formed on the detector;

- Figure 17 depicts examples of reference irradiance spots formed by reference irradiance beams having various foci and/or astigmatisms;

- Figure 18 schematically illustrates an example of the intersection of reference irradiance beams having various foci and/or astigmatisms with the detector plane;

- Figure 19 schematically illustrates at least part of a metrology apparatus;

- Figure 20 schematically illustrates an arrangement for obtaining a spectral calibration of a measurement illumination using the metrology apparatus; and

- Figure 21 schematically illustrates a method according to the present disclosure.

## DETAILED DESCRIPTION

**[0074]    [0072]** Before describing embodiments of the invention in detail, it is instructive to present an example environment in which embodiments of the present invention may be implemented.

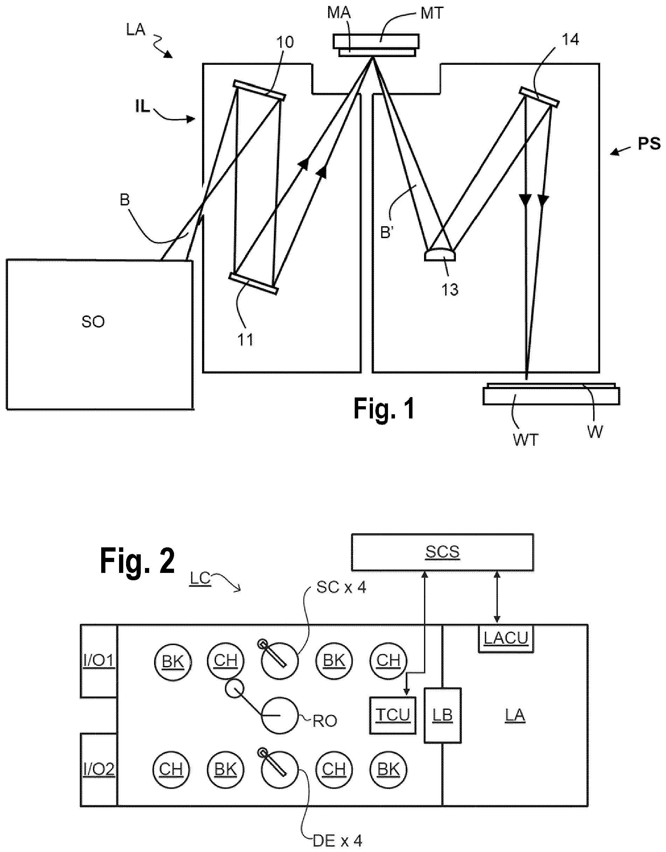

**[0075]    [0073]** Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT.

The projection system PS may apply a reduction factor to the patterned EUV radiation beam B', thus forming an image with features that may be smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source, high harmonic generation (HHG) source or a free electron laser (FEL) may be used to generate EUV radiation.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

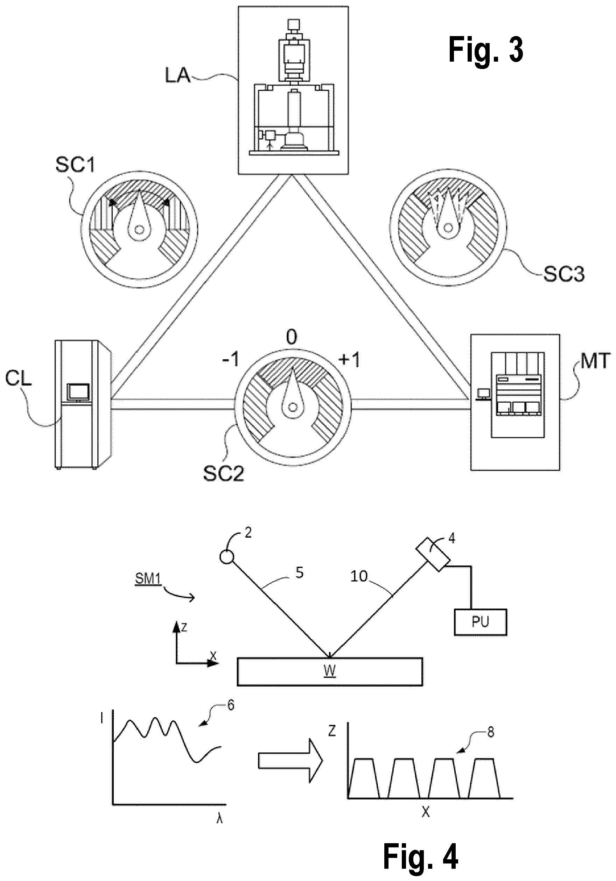

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic patterning apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

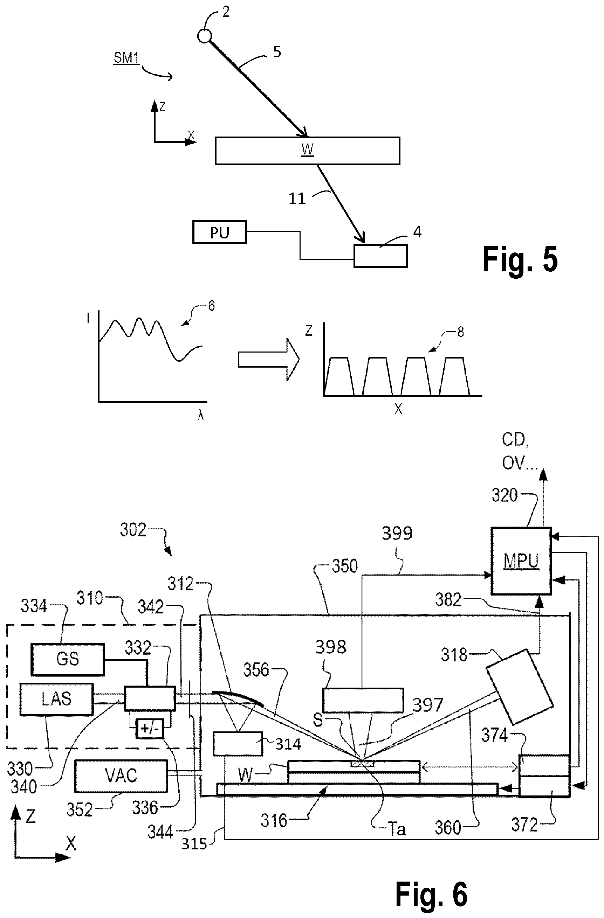

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source, as well as other types of sources, may have a gas target and be a gas jet/nozzle source, a capillary/fiber source or a gas cell source. The HHG source, as well as other types of sources, may have a solid or liquid target. Although HHG source with gas target is described in the text below, it will be appreciated that the invention is not limited to HHG source with gas target and may be used in HHG source with solid or liquid target and other types of source with any target. The gas target, solid target and liquid target may be referred as generating/target medium.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10$\mu$m, for example in the region of 1 $\mu$m (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen ($N_2$), Oxygen ($O_2$), Argon (Ar),

Krypton (Kr), Xenon (Xe), Carbon dioxide and the combination of them. These may be selectable options within the same apparatus. The emitted radiation may contain multiple wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 μm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use HHG or any other types of sources mentioned above to obtain radiation at the desired wavelength(s).

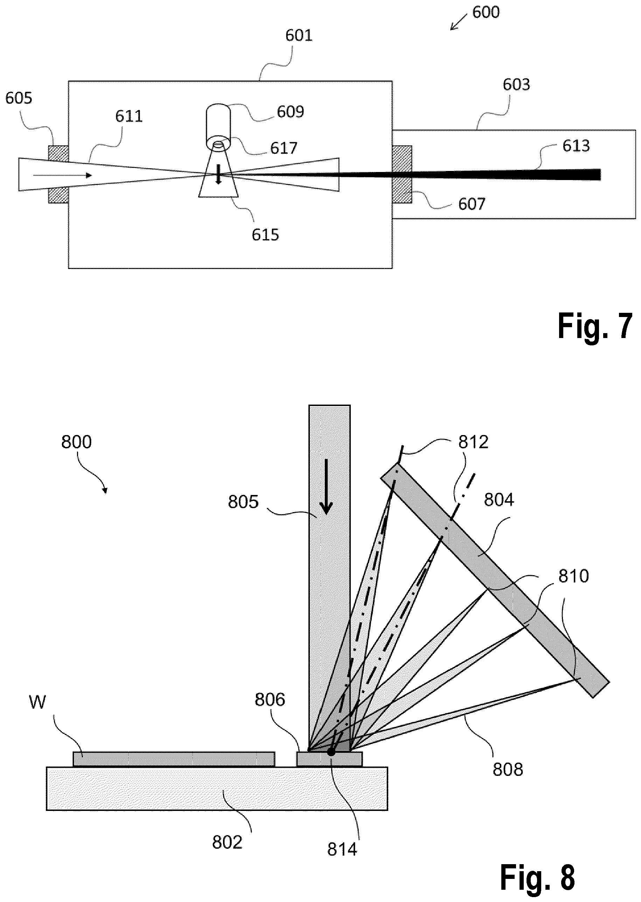

Figure 7 shows a simplified schematic drawing of an embodiment 600 of an illumination source 310, which may be the illumination source for HHG. One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermal deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Although specific reference is made to HHG, it will be appreciated that the invention, where the context allows, may be practiced with all radiation sources. In one embodiment, the radiation source is a laser produced plasma (LPP) source as mentioned above, for hard X-ray, soft X-ray, EUV, DUV as well as visible illumination generation. In one embodiment, the radiation source is one of liquid metal jet source, inverse Compton scattering (ICS) source, plasma channel source, magnetic undulator source, free electron laser (FEL) source, compact storage ring source, electrical discharge produced plasma source, rotating anode source, solid anode source, particle accelerator source, and microfocus source.

Figure 8 illustrates at least part of an apparatus 800 according to the present disclosure. The apparatus 800 may correspond to part of the metrology apparatus 302 described herein.

The apparatus 800 comprises a detector 804. The detector 804 may be referred to as an image sensor. In some examples, the detector 804 is configured to measure one or more non-zero diffraction orders of an illumination diffracted from a structure. In general, the detector 804 may comprise a plurality of pixels. In some examples, the apparatus 800 may comprise two detectors 804 (which may be referred to as a first detector and a second detector, respectively). In some examples, the apparatus 800 may comprise more than two detectors. The apparatus 800 may further comprise a substrate support 802 which may support a substrate W (e.g. a wafer). Reference illumination 805 (e.g. a laser beam, optionally a collimated laser beam) is provided by a reference illumination source (not shown) and directed onto, or into, an optical element 806. In some examples, described in more detail below, the reference illumination 805 may be coupled into the optical element 806 via an optical fiber. As shown in Figure 8, the optical element 806 may be disposed on the substrate support 802 (e.g. attached to the substrate support 802). In some examples, the optical element 802 may be attached (e.g. glued) to the substrate W itself, or the optical element 802 could even be integrated with the wafer W as a part of the substrate W (e.g. as a structure on the substrate W).

The optical element 806 is configured to produce, from the reference illumination 805 incident on the optical element 806, a plurality of reference irradiance beams 808 incident on the detector 804. Where the reference irradiance beams 808 intersect with the detector 804, a plurality of reference irradiance spots 810 are formed on the detector 804. The reference irradiance spots 810 collectively form a reference irradiance pattern. It will be appreciated that Figure 8 is a side view of the apparatus 800, and that the reference irradiance pattern may be a two-dimensional (2D) pattern on the detector 804.

Preferably, the optical element 806 is configured (e.g. designed) such that reference irradiance spots 810 are smaller than a pixel size of the detector 804. Preferably, the optical element 806 is configured such that the focus of the reference irradiance beams 808 is at or around the plane of the detector 804. For example, with a numerical aperture NA = 0.1 and wavelength 633 nm, the reference irradiance spot size should be around 4 $\mu$m in diameter, which is smaller than a typical image sensor pixel diameter (e.g. around 10 $\mu$m, around 15 $\mu$m, around 20 $\mu$m, or around 25 $\mu$m in some examples). Preferably, the optical element 806 is configured such that at least 3 reference irradiance spots 810 are produced at the detector 804. The optical element 806 may be configured such that 10s, 100s, or even 1000s of reference irradiance spots 810 are produced. In an example, a grid of 100 reference irradiance spots 810 may be spread out over the detector 804. In one embodiment, the grid of reference irradiance spots 810 is evenly spaced. In one embodiment, the grid of reference irradiance spots 810 need not necessarily be evenly spaced.

The position related parameter of the detector 804 may be determined by obtaining the pixel coordinates of the reference irradiance spots 810 on the detector 804 (e.g. by capturing an image using the detector 804 when the reference irradiance beams 808 are incident on the detector 804).

In an example, the wavelength of the reference illumination 805 is 633 nm (e.g. produced by a HeNe laser as the reference illumination source). However, other wavelengths may be used, such as infrared (IR), near-infrared (NIR), visible, near-ultraviolet (NUV), ultraviolet (UV), extreme ultraviolet (EUV) or X-ray wavelengths.

Because the size of the reference irradiance spots 810 (at the plane of the detector 804) is small, and the wavelength of the reference illumination 805 is known, a large amount of data will be available for an accurate measurement of the position of the detector 804 (in 6 degrees of freedom, DoF) relative to the position of the optical element. For example, a position related parameter according to the present disclosure may comprise a distance of the detector 804 from the optical element 806. A position related parameter may comprise a distance of the detector 804 from the optical element 806 in a particular dimension in 3D space, i.e. x, y, or z. In some examples, a position related parameter may comprise a rotation parameter of the detector 804.

The optical element 806 may be designed so that, in combination with a known angle of incidence and azimuthal angle of the reference illumination 805 with respect to the optical element 806, the chief ray vectors 812 of each reference irradiance beam 808 are also known. A computer generated hologram (CGH) may be particularly suitable as an optical element 806 that can be designed in this way. For example, the optical element 806 may comprise a glass pate on which a CGH is formed. In general, suitable optical elements 806 may comprise one or more of a phase mask, an amplitude mask, a (2D) grating, a spatial light modulator, a hologram, a CGH, a pinhole mask, and/or a plurality of curved (e.g. parabolic) mirrors. The optical element 806 may be a few mm (e.g. 1 to 20 mm) in diameter, which may be convenient for illumination by a laser beam. In some examples described herein, the optical element 806 may comprise an integrated optics device such as a photonic integrated circuit (PIC). A hologram or CGH may be implemented as a phase hologram, an amplitude hologram or a combination thereof. The hologram may be a thin hologram or a volume hologram.

The position related parameter(s) of the detector 804 (e.g. the 6 DoF of the detector 804) may be fitted such that the observed coordinates (i.e. pixel coordinates) of the reference irradiance spots 810 match the points at which the chief ray vectors 812 of the reference irradiance beams 808 intersect the plane of the detector 804.

Alternatively, or in addition, the pixels may be mapped to the polar angles of the chief rays.

For the purposes of metrology, a reference point 814 may be defined on the optical element 806 (e.g. at or near the centre of the optical element 806). Following calibration of the apparatus 800 (i.e. once the position related parameter(s) of the detector 804 relative to the optical element 806 have been determined), the substrate stage 802 may be moved such that a metrology target (e.g. located on a substrate W) is exactly in the location where the reference point 814 was during the calibration. In another example, the position of the substrate W, or a metrology target (which may be on a substrate W) may be determined using the position related parameter(s) of the detector 804 relative to the optical element 806, and additionally based on a known distance between the substrate W or metrology target and the optical element 806.

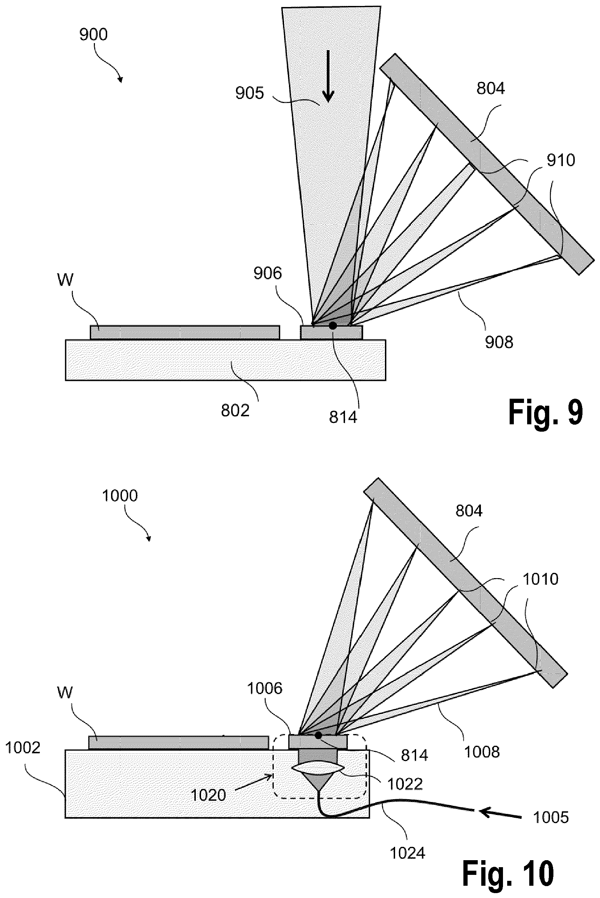

Figure 9 illustrates a similar apparatus 900 to the apparatus 800 illustrated in Figure 8. In Figure 9, reference illumination 905 (which may not be collimated, as shown in Figure 9, but which may be collimated in other examples) is incident on an optical element 906. The optical element 906 may comprise a periodic pattern (e.g. grating pattern), which may be cheaper and easier to produce than some examples of optical elements described in relation to Figure 8 (for example, the periodic optical element 906 may be cheaper and easier to produce than a GCH or a PIC). The reference irradiance beams 908 produced by the reference illumination 905 incident on the periodic optical element 906 may not all have their focuses at the plane of the detector 804, resulting in reference irradiance spots 910 of differing sizes on the detector 804.

In some examples, at least a portion of the optical element is transmissive to the reference irradiation.

Figure 10 illustrates a further example of an apparatus 1000 according to the present disclosure, comprising an optical element 1006 that is at least partially transmissive to reference illumination 1005. In the example of Figure 10, the optical element 1006 is illuminated from below (e.g. from a side of the optical element 1006 opposite to that of the detector 804. The reference illumination 1005 may be provided via an optical fiber 1024 (e.g. a single-mode fiber), e.g. through an adapted substrate support 1002. An optional collimation lens 1022 may be used to collimate the reference illumination 1005 incident on the optical element 1006. In some examples (not shown), the reference illumination source could be integrated directly with the optical element 1006, and the combination of the reference illumination source and the optical element 1006 may be integrated with the substrate support 1002. Reference irradiance beams 1008, and therefore reference irradiance spots 1010 incident on the detector 804, are formed by the interaction of the reference irradiation 1005 with the transmissive optical element 1006. The optical element 1006, at least a portion of which is transmissive to the reference illumination 1005, may comprise a CGH, a grating, and/or any other suitable type of optical element described herein or otherwise. The optical element 1006, lens 1022, and/or reference illumination source may be collectively referred to as a calibration device 1020, which may be integrated with a substrate support 1002. A transmissive optical element 1006 may therefore, in some examples, enable a more compact, or modular, apparatus. The calibration device 1020 may advantageously be aligned and tested prior to integration with a metrology apparatus.

In some examples, the reference illumination may be aligned with respect to the optical element based on a reflection of the reference illumination by the optical element. That is, at least a portion of the optical element may be reflective to the reference illumination. In some examples, the optical element may comprise a first portion that is reflective to the reference illumination (which may be referred to as an alignment portion, or alignment guide), and a second portion that is transmissive to the reference illumination.

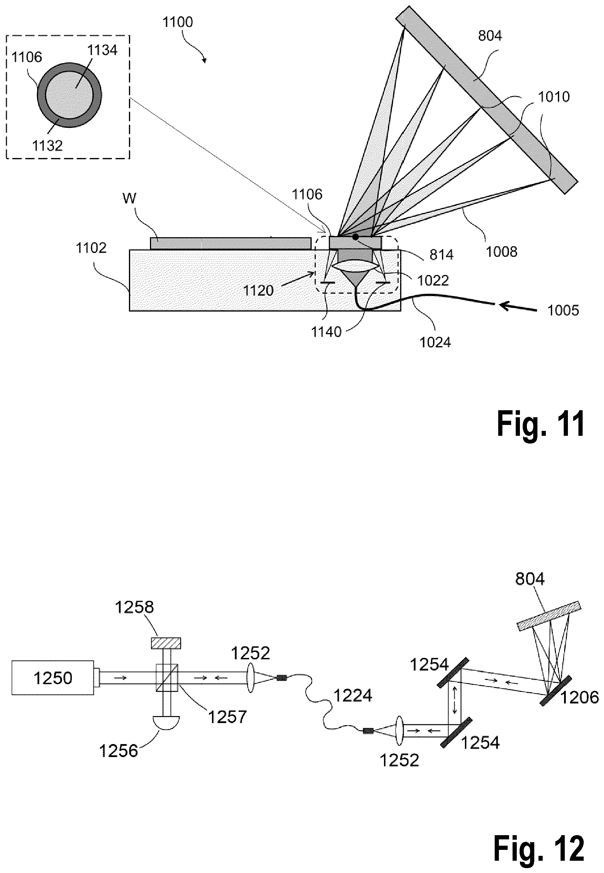

Figure 11 illustrates an example of an apparatus 1100 that is similar to the apparatus 1000 illustrated in Figure 10, in which the optical element 1106 comprises a transmissive portion 1134 and an alignment guide 1132 that is reflective to the reference illumination 1005 (see plan view of the optical element 1106 in the inset of Figure 11). The apparatus 1100 may further comprise one or more alignment marks or detectors 1140 (e.g. photodiodes) arranged to facilitate alignment of the reference illumination 1005 (e.g. alignment of the reference illumination source and/or optical fiber 1024) with respect to the optical element 1106 by detecting and/or enabling visualization of reference illumination reflected by the alignment guide 1132. In some examples, as illustrated in Figure 11, the alignment marks or detectors 1140 may form part of the calibration device 1120, and/or may be integrated in an adapted substrate support 1102. The alignment guide 1132 may comprise, for example, a reflective coating such as Cr. As illustrated in Figure 11, the alignment guide 1132 may be disposed around a periphery of the optical element 1106. Advantageously, in-line alignment of the apparatus 1100 may be performed without requiring additional measurement time.

Alternatively, the optical element may be illuminated from above (i.e. from a same side as that of the detector), as shown in Figures 8 and 9. The reference illumination can also be aligned with respect to the optical element based on reflection of the reference illumination by the optical element in this arrangement.

Figure 12 schematically illustrates an example of an arrangement in which the reference illumination may be aligned with respect to the optical element 1206 based on reference illumination reflected by the optical element 1206. The arrangement illustrated in Figure 12 may correspond to an apparatus described herein, such as the apparatus 800 illustrated in Figure 8, and/or the apparatus 900 illustrated in Figure 9. Reference illumination provided by a reference illumination source 1250 (e.g. a laser) may be directed towards the optical element 1206 (e.g. by a combination of lenses 1252, an optical fiber 1224, and/or one or more steering mirrors 1254). Part of the reference illumination is reflected by the optical element 1206 and propagates back towards the reference illumination source 1250, and is partly diverted by a beam splitter 1257 towards an alignment detector 1256 (e.g. a photodiode) to facilitate alignment. The optical element 1206 may be designed such that the beam is propagated back towards the reference illumination source 1250 if the optical element 1206 is illuminated at a particular angle. A beam dump 1258 may also be employed, e.g. to dump reference illumination emitted by the reference illumination source 1250 towards the optical element 1206 that is reflected by the beam splitter 1257. In an example, for an optical element 1206 comprising a CGH designed for illumination at a 30 deg angle of incidence, a line grating with a pitch equal to the reference illumination wavelength would be suitable for the arrangement of Figure 12. If the reference illumination hits the CGH at the correct angle, the back-reflected illumination will travel back through the optical fiber 1224 and reach the alignment detector 1256. The steering mirror(s) 1254 may be used to maximize the signal at the alignment detector 1256.

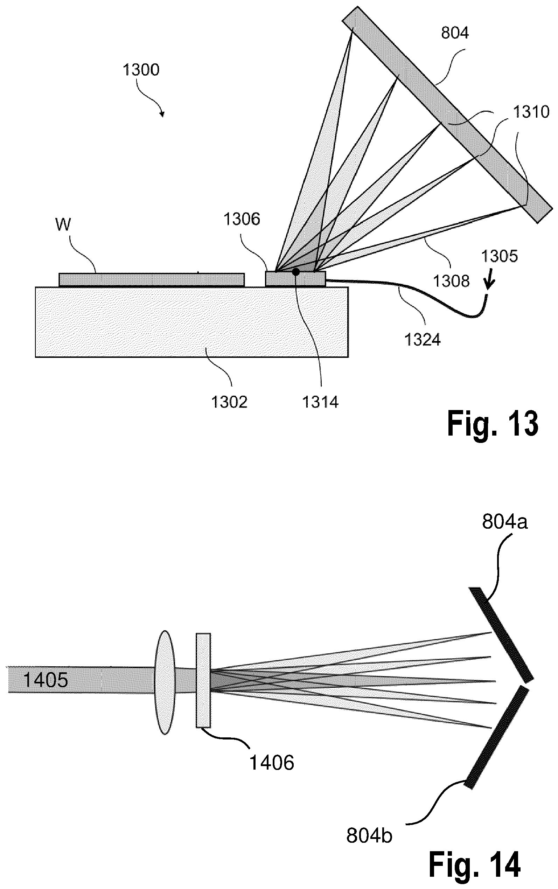

In some examples, such as the apparatus 1300 illustrated in Figure 13, the reference illumination 1305 is directly coupled into the optical element 1306 via an optical fiber 1324. For example, the optical element 1306 (which may be positioned on a substrate support 1302) may comprise an integrated optical device such as a photonic integrated circuit (PIC). The integrated optical device is designed (configured) such that the foci and/or chief ray vectors of the reference irradiance beams 1308 are known and can be used to determine the position of the detector 804 relative to the optical element 1306 based on the reference irradiance pattern comprising the reference irradiance spots 1310. As described herein, a reference point 1314 may be defined on the optical element 1306.

Advantageously, an optical element 1306 comprising an integrated optical device, such as a PIC, may result in reduced stray light (e.g. due to interference/speckle effects), and/or improved tolerance to reference illumination beam pointing/beam profile quality.

An integrated optical device such as a PIC may produce the reference irradiance beams from a plurality of point sources, produced from the reference illumination. The point sources do not have to be exactly in the same plane as any substrate to be measured, as long as their position is known accurately.

In some examples, as illustrated in Figure 14, the reference irradiance pattern may be formed on a first detector 804a and a second detector 804b. It will be appreciated that any of the apparatuses described herein may comprise first and second detector, and may more generally comprise any number of detectors 804, and that the single detector 804 illustrated in Figures 8 to 13 is shown merely for clarity.

Figure 14 illustrates an example in which the calibration of the position related parameter(s) of the detector(s) 804a, 804b relative to an optical element 1406 may be performed "offline" using the reference illumination 1405, that is without the presence of a substrate support, or outside of the metrology apparatus.

The position related parameter(s) of the second detector 804b may, in some examples, be determined with respect to the position related parameter(s) of the first detector 804a, thereby fixing 6 out of the 12 DoF (in the case of a dual-detector arrangement). In this example, the position-related parameter(s) of the first detector 804a may be determined by any of the methods and/or apparatuses described herein.

In some examples, the optical element may comprise a spatial light modulator (SLM). A SLM may be particularly advantageous in situations where the detector is displaced over a large range of distances.

In some examples, the optical element may comprise a test pattern on a substrate W itself. The test pattern could comprise, for example, a grating (e.g. 2D grating), or a CGH, or any other suitable optical element as described herein. The test pattern could be made reflective and/or transmissive to the reference illumination according to the desired arrangement.

In some examples, the reference point described herein may comprise a small (e.g. 20-40 $\mu$m in diameter) unpatterned area of the optical element. This area can be aligned with a focus of measurement illumination. If all of the measurement illumination energy is incident on this area, there will be a strong specular reflection and little or no diffraction. Alternatively, the reference point could be marked by a fine pattern (e.g. having a pitch smaller than the wavelength of the reference illumination) over this area, which would generate a strong and recognizable measurement illumination (e.g. SXR) diffraction pattern.

The detector 804 may comprise a filter for blocking residual infrared light produced by the generation of measurement illumination. The wavelength and/or source power for the reference illumination may be selected so that this filter will not prevent the calibration described herein from working.

In some examples, instead of or in addition to fitting 6 DoF of the sensor, a grid mapping from pixel coordinates to pupil coordinates could be produced. Pupil coordinates are the x and y components of the unit vectors from the reference point of the optical element, in a coordinate system where the z-axis is perpendicular to the plane of the substrate W. For example, if a CGH generates a grid of 10x10 known ray vectors (10x10 known pupil vectors), the pixel coordinates of where these vectors intersect with the detector are obtained;

an interpolation function can then be constructed to map from pixel coordinates to pupil vectors. However, if the detector is not flat due to mechanical stress, the 6 DoF fit may not be accurate; instead, one could create a direct mapping instead of going through a parametrized mapping with too few parameters.

Some examples of suitable reference irradiance patterns will now be described.

In some examples, the reference irradiance pattern may comprise a diffraction pattern (e.g. produced by any suitable optical element or mask). For example, a pattern could be produced via the Talbot effect. In some examples, the reference irradiance pattern may be produced by interference. For example, the optical element could comprise a pinhole mask comprising a few (e.g. 3) pinholes having a diameter of the order of the reference illumination wavelength (illuminated from below). Light may diffract from these pinholes and the interference between the light from the pinholes may generate a pattern on the image sensor. This could generate 10 thousand spots or more. A similar effect could be achieved for an optical element illuminated from above using an optical element comprising a plurality of curved (e.g. paraboloid) mirrors.

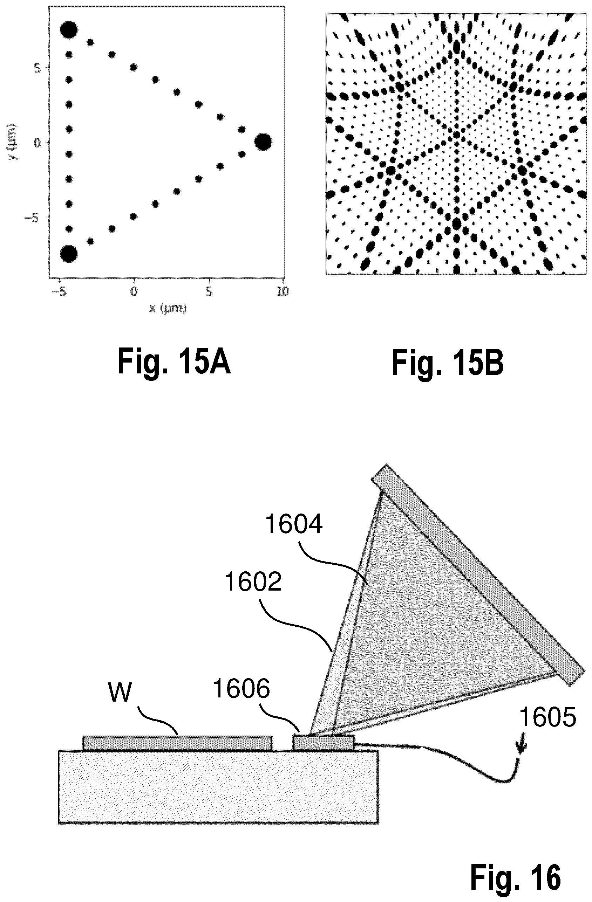

Figure 15A illustrates an example of a series of point sources that may be formed by e.g. an integrated optical device, such as a PIC, as described herein. The point sources may also be formed by any other suitable type of optical device (e.g. a CGH or a plurality of curved mirrors as described herein). Figure 15B illustrates an example of a reference irradiance pattern produced by the point sources of Figure 15A. It will be appreciated the sizes of the spots in Figures 15A and 15B represent the brightness of the spots (i.e. larger spots are brighter than smaller spots), and that the spots in Figures 15A and 15B may in practice be the same or similar sizes. The point sources of Figure 15A are arranged in a triangle around an origin, the origin being the reference point of the optical element described herein. In some examples, the triangle need not be an equilateral triangle. In some examples, the reference point (origin) could be defined at a location outside the triangle. While the distances between the points at the corners of the triangle in Figure 15A are shown to be approximately 15 $\mu$m, it will be appreciated that much larger distances may be used in practice to achieve a much tighter reference irradiance pattern (e.g. having a spot pitch of 3-4 pixels or less). The dimmer points, between the corners of the triangle, may be arranged on a grid with equidistant spacing, i.e. such that the two nearest neighbors of the dimmer points are always at the same distance. This ensures that the diffraction pattern from the dimmer points is aligned with the pattern from the brighter points.

Three point sources arranged in a triangle may result in a dense pattern (or constellation) on the detector, as shown in Figure 15B. A number of dimmer point sources result in the "mesh" of brighter dots in the pattern on the detector. If the relative phases of the light emitted by the point sources are known, as well as the positions of the point sources, then the position of the detector can be inferred from the positions of the spots on the detector. In other examples, other numbers of point sources could be used, for example 4 point sources. In some examples, pairs of point sources may be illuminated (i.e. by reference illumination arriving at, or incident on, the optical element, e.g. the PIC) one pair at a time. For example, 3 or 4 point sources could be illuminated two at a time (i.e. as two pairs of point sources, illuminated one pair at a time). A pair of point sources may produce a reference irradiance pattern comprising stripes rather than a dot pattern. According to the present disclosure, a reference irradiance spot may comprise a stripe.

If the distance between the point sources is d, then the angular separation of the spots (from the center of the point-source pattern; the origin in Figure 15A) will be approximately $\lambda/d$ (in radians). Ideally, d is chosen such that the spot pitch on the detector is between 3 and 4 pixels, which means the spots are as close to each other as possible, while still being visible as separate spots. The Nyquist limit is at a spot pitch of 2 pixels; d may be chosen such that the spot pitch is only slightly above this limit, for example a spot pitch between 2.1 and 3 pixels. In an example, the pixel size is between 5 $\mu$m and 15 $\mu$m (e.g. 13.5 $\mu$m), at a distance of between 20 mm and 50 mm (e.g. 40 mm) from this optical element, from which an optimal point-source distance d between around 470 $\mu$m and around 900 $\mu$m, e.g, between around 470 $\mu$m and around 630 $\mu$m, would follow (e.g. d may be approximately 500 $\mu$m, 525 $\mu$m, 550 $\mu$m, 575 $\mu$m, or 600 $\mu$m in some examples). The pattern in Figure 15B is for $d$ = 15 $\mu$m, which causes a coarser spot pattern that is easier to visualize. In this context, $d$ refers to the largest distance between two point sources in a point-source pattern that are contributing to a diffraction pattern on the sensor at the same time.

It may be hard to disambiguate detector positions that are shifted by a single dot-to-dot distance (for example, 3 pixels). For this disambiguation, a second point-source pattern may be used, i.e. the smaller markers in Figure 15A, which are spaced more closely than the three main markers. This second point-source pattern generates the brighter spots in Fig. 15B. The coarse position estimate ($\pm$1 pixel) can be done based on the second pattern, while the fine sub-pixel position estimate can be done based on the fine pattern.

The main and second point-source patterns may be active at the same time. Alternatively, they could be in two separate optical elements, e.g. both attached to a substrate support. The substrate support can be consecutively moved such that the first and then the second optical elements are in the target position (at which the measurement illumination is to be focused). Two separate patterns would be recorded; one for the coarse estimate of the detector position, the other for the fine (sub-pixel) estimate. In some examples, an optical element may comprise two patterns on a same optical element, e.g. a PIC having two patterns may be illuminated with respect to each pattern by two different optical fibers, and each respective pattern may be selectable via a switch.

An example of generation of a coarse pattern 1602 and a fine pattern 1604 by an optical element 1606 illuminated by a reference illumination 1605 is illustrated schematically in Figure 16.

The data processing can be made highly robust against background stray light. For example, the recorded image may be transformed to pupil space, using a coarse estimate of the detector position. Pupil space is a representation of ray vectors from the center of the optical element (the origin in Figure 15A as described above), where the z-axis is normal to the plane of the optical element and/or the plane of the point sources. If a pixel of the detector is at position $r = (x, y, z)$, then the corresponding pupil coordinates are $(x/\|r\|, y/\|r\|)$. In pupil space, the reference irradiance pattern is nearly periodic with a known unit cell. The signal may be filtered using standard Fourier methods. When the reference irradiance pattern is generated from point sources (e.g. by a PIC, or a CGH or plurality of curved mirrors in some examples), as described herein, the positions of the reference irradiance spots maybe affected by the phase differences of the points sources, rather than their amplitudes. Therefore, the pattern is made less sensitive to the quality of the beam profile.

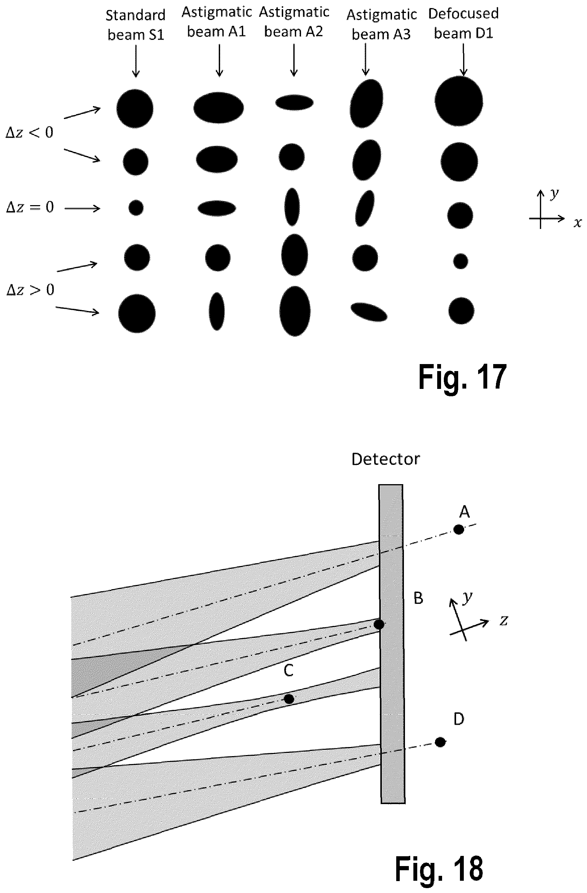

The optical element may be configured, in some examples, to produce astigmatic reference irradiance beams. In some examples, the optical element may be configured to produce reference irradiance beams that are out of focus on the designed detector plane. The spot shape at the detector will provide information about the distance of the detector plane to the optical element (e.g. the reference point). This is illustrated in Figure 17. A standard beam may have a single focus with a mostly round spot shape. An astigmatic focused beam may have two line foci. A standard beam may have a larger spot diameter on the detector if the sensor plane is out of the focus (offset $\Delta z \neq 0$) (column S1 in Figure 17).

An astigmatic beam A1 can be designed to have one line focus at $\Delta z = 0$ and another line focus at some $\Delta z > 0$. From the spot shape, the $\Delta z$ value can be estimated, e.g. for $\Delta z > 0$. Another astigmatic beam A2 is designed to enable for estimating $\Delta z < 0$. Beam A3 shows that the orientation of the line foci can be designed arbitrarily. Beam D1 is designed to be non-astigmatic but have a deliberate defocus at the nominal (designed) detector plane. Combining information from beams S1 and D1 will also allow one to estimate the $\Delta z$ value. In general, one or both of a astigmatic and/or defocused beams may be employed to determine $\Delta z$.

For example, the optical element may be configured to produce many (e.g. 10s or 100s) of reference irradiance beams, each with different (and known) focus points, so that for each spot on the detector, both in-plane $(x, y)$ and out-of-plane $(z)$ position information is available. By designing the optical element to generate beams with focus points at various $\Delta z$ values, there will be (a) enough beams with a focus on the sensor plane (for accurate $x$ and $y$ positions) and (b) enough beams with a focus away from the sensor plane (which may be better for accurate $z$ positions). This is illustrated in Figure 18; beam B in has a focal point on the detector plane. The beam diameter in is small, but the $z$ coordinate cannot be inferred from the spot diameter accurately, because the spot diameter as a function of $z$ has zero derivative at that point. For beams A, C, D, the spot diameter is a better metric for the $z$ position of the detector plane at that point. If the detector as a whole is displaced towards negative $z$, then beam C will be in focus (ensuring an accurate $x, y$ position), whereas beam B will be out of focus (ensuring an accurate $z$ position) and beams A and D will be so far out of focus that the accuracy of all of $x, y, z$ will be low.

In some examples, the $z$ information may not be used (e.g. because $z$ is also encoded in the distance along $x$ or $y$ between the spots on the detector). Overall accuracy is still improved because there will always be enough points with good $x$ and/or $y$ accuracy due to the corresponding beams having a focus on the detector plane.

The position related parameter(s) of the detector may be employed in obtaining a spectral calibration, e.g. for a metrology apparatus.

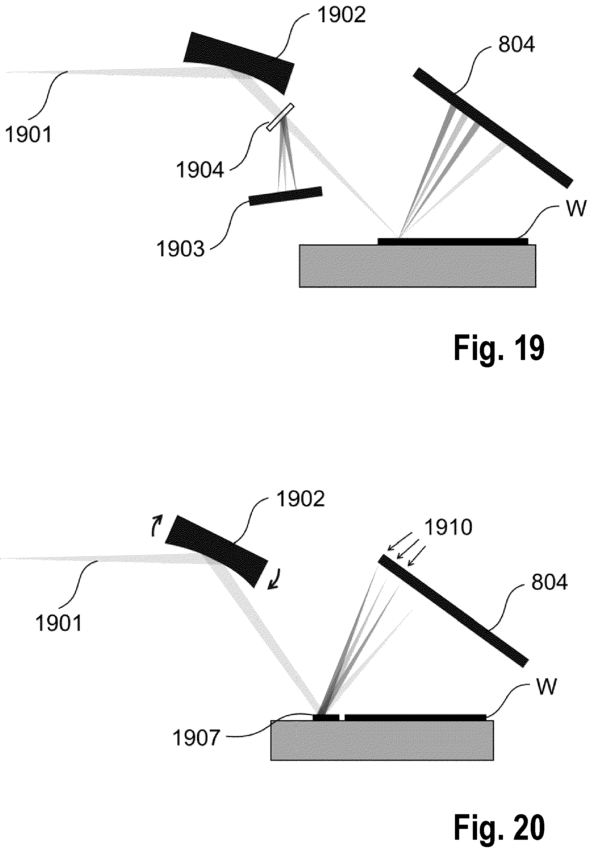

Figure 19 illustrates an example of part of a metrology apparatus according to the present disclosure. The part of the metrology apparatus illustrated in Figure 19 may correspond to part to the scatterometer illustrated in Figure 6. A measurement illumination 1901 is directed onto a metrology target on a substrate W (e.g. a wafer). For example, the measurement illumination 1901 may be broadband illumination and may include radiation in the hard X-ray (HXR), soft X-ray (SXR), extreme ultraviolet (EUV), visible to near-infrared (IR) and/or IR wavelength range. The measurement illumination 1901 may be generated by the radiation source SO, 310 illustrated in e.g. Figures 1 and 6 and described herein.

Diffraction from the metrology target onto the detector 804 is captured. The diffraction efficiency of the target pattern for the various wavelength components can be measured and translated into estimates for parameters of interest such as overlay and critical dimension of the substrate W.

As shown in Figure 19, the measurement illumination 1901 may be directed towards the substrate W via a mirror 1902 (e.g. a toroid mirror). The measurement illumination 1901 may be monitored using an illumination monitoring sensor 1903 (e.g. an array sensor). For example, part of the measurement illumination 1901 may be diffracted onto the illumination monitoring sensor 1903 by a transmissive diffraction grating 1904. In some examples, the transmissive diffraction grating 1904 may be integrated with the mirror 1902.

According to the present disclosure, as shown in Figure 20, the measurement illumination 1901 may be directed onto a fiducial target 1907. The measurement illumination 1901 may comprise a plurality of distinct spectral peaks (e.g. approximately 25 sharp peaks), for example if the measurement illumination 1901 is produced by HHG.

The fiducial target 1907 may comprise a periodic grating (which may be similar to the target patterns, but may be optimized for the purposes of this calibration). In some examples, the fiducial target 1907 may comprise a grating having a variable line spacing (VLS) and/or having curved lines. These features may cause all line foci of the wavelength components incident on the detector 804, which may otherwise be curved lines that are not all in focus on the plane of the detector 804, to be straight and in focus, and thereby improve accuracy.

In some examples, the mirror 1902 may be rotated, or tilted, such that the measurement illumination 1901 is directed towards the fiducial target 1907 (e.g. to avoid the illumination monitoring sensor 1903 and/or the diffraction grating 1904 for the purposes of calibration). Rotating the mirror 1902 may also ensure that the wavelength components 1910 of the diffracted measurement illumination are in focus on the detector 804. For example, with grazing-incidence optics, such a mirror tilt may introduce astigmatism in the beam and may result in a defocus that will cause the measurement illumination beam to be focused onto the detector 804 rather than onto the substrate W (the astigmatic beams will form line foci, with the lines oriented perpendicular to the plane of the page in Figure 20).

Thus, each wavelength component is in focus. When focused, spot sizes on the detector may be similar to the pixel size (e.g. around 10 $\mu$m, around 15 $\mu$m, around 20 $\mu$m, or around 25 $\mu$m FWHM). With the detector position known (e.g. using any of the methods or apparatuses described herein to determine a position related parameter of the detector 804), the diffraction pattern on the detector 804 can be translated into a wavelength spectrum with a calibrated wavelength axis. This spectrum can be used to assign wavelength values to the pixels on the illumination monitoring sensor 1903 shown in Figure 19. In particular, the peaks of the spectrum can be used to match the calibrated spectrum on the detector 804 to the spectrum on the illumination monitoring sensor 1903.

In some examples, if a diffraction efficiency spectrum of the fiducial target 1907 is known, an intensity axis of the spectrum can also be calibrated.

In some examples, the area under each peak can be matched to the calibrated area under the peak on the spectrum from the detector 804.

Following obtaining the calibration(s), the mirror 1902 may be rotated back to the position required for metrology.

If the raw spectrum as measured on the illumination monitoring sensor 1903 is some kind of signal $y(x)$ where $x$ is the position on the sensor and $y$ is the signal level (for example, in ADU $\mu$m$^{-1}$ s$^{-1}$ units, where ADU

refers to analog-to-digital units), then matching the peaks will result in a mapping function $f(\lambda)$ to map wavelength to position $x$ and a second mapping function $g(\lambda)$ to map digital signal levels to radiometric units such as spectral flux $\Phi_\lambda(\lambda)$ in W nm$^{-1}$ units according to the expression:

$$\Phi_\lambda(\lambda) = y\big(f(\lambda)\big) \cdot g(\lambda).$$

In some examples, multiple diffraction patterns may be obtained for different rotation angles of the mirror 1902. Effectively resampling the spectrum in this way may improve sub-pixel accuracy.

The fiducial target 1907 is preferably large enough to be illuminated by the entire out-of-focus measurement illumination beam.

The pitch of the fiducial target 1907 is preferably small enough to spread out the full SXR wavelength range (e.g. around 100 nm).

Preferably, the fiducial target 1907 exhibits a smooth spectral response. Preferably, the fiducial target 1907 suppresses the second diffraction order to prevent ambiguity between overlapping first and second diffraction orders, e.g. by having a pitch with a duty cycle close to 50%.

Preferably, the fiducial target has a known diffraction efficiency spectrum (e.g. the diffraction efficiency spectrum may be calibrated separately).

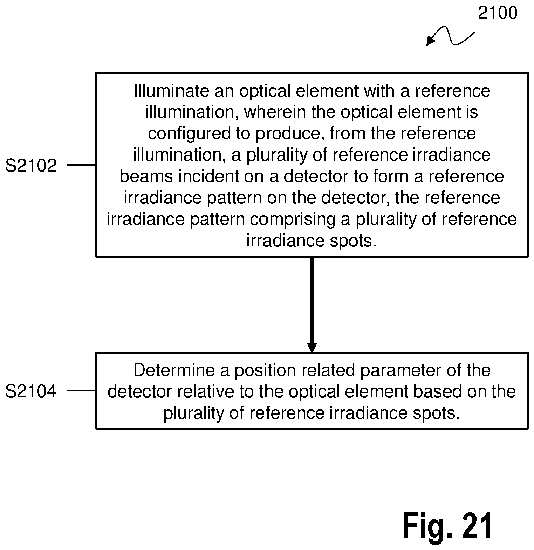

Figure 21 illustrates an example of a method 2100 according to the present disclosure. The method 2100 may be performed using, e.g., any of the apparatuses or arrangements described and illustrated herein.

At S2102, the method 2100 comprises illuminating an optical element with a reference illumination, wherein the optical element is configured to produce, from the reference illumination, a plurality of reference irradiance beams incident on a detector to form a reference irradiance pattern on the detector, the reference irradiance pattern comprising a plurality of reference irradiance spots.

For example, the detector may correspond to the detector 804 described and illustrated herein. The optical element may correspond to one or more of a phase mask, an amplitude mask, a (2D) grating, a spatial light modulator, a hologram, a CGH, a pinhole mask, and/or a plurality of curved (e.g. parabolic) mirrors as described herein. The reference irradiance pattern may comprise, for example, spots formed by reference irradiance beams focused on the detector and/or not focused on the detector, and reference irradiance beams having astigmatic and/or non-astigmatic beam profiles as described herein (e.g. as illustrated in Figure 17).

At S2104, the method 2100 comprises determining a position related parameter of the detector relative to the optical element based on the plurality of reference irradiance spots. For example, the position related parameter may be determined by any of the fitting and/or mapping techniques described herein.

The method 2100 may be carried out, at least partly, by a processor as described herein.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. For example, a "processor" as described and referred to herein may correspond to the unit MPU. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:

1. A method comprising:

illuminating an optical element with a reference illumination, wherein the optical element is configured to produce, from the reference illumination, a plurality of reference irradiance beams incident on a detector to form a reference irradiance pattern on the detector, the reference irradiance pattern comprising a plurality of reference irradiance spots; and

determining a position related parameter of the detector relative to the optical element based on the plurality of reference irradiance spots.

2. A method according to clause 1, wherein the reference irradiance pattern comprises at least three reference irradiance spots.

3. A method according to clause 1 or 2, wherein the optical element comprises a phase mask.

4. A method according to any one of the preceding clauses, wherein the optical element comprises an amplitude mask.

5. A method according any one of the preceding clauses, wherein the optical element comprises a grating.

6. A method according to any one of the preceding clauses, wherein the optical element comprises a spatial light modulator.

7. A method according to any one of the preceding clauses, wherein the optical element comprises a hologram.

8. A method according to any one of the preceding clauses, wherein the optical element comprises a computer generated hologram.

9. A method according to any one of the preceding clauses, wherein the optical element comprises a pinhole mask.

10. A method according to any one of the preceding clauses, wherein the optical element comprises a plurality of curved mirrors.

11. A method according to any one of the preceding clauses, wherein at least a portion of the optical element is reflective to the reference illumination.

12. A method according to any one of the preceding clauses, wherein at least a portion of the optical element is transmissive to the reference illumination.

13. A method according to any one of the preceding clauses, wherein the optical element comprises a photonic integrated circuit.

14. A method according to any one of the preceding clauses, comprising aligning the reference illumination with respect to the optical element based on a reflection of the reference illumination by the optical element.

15. A method according to any one of the preceding clauses, wherein illuminating the optical element with the reference illumination comprises providing the reference illumination via an optical fiber.

16. A method according to any one of the preceding clauses, wherein the detector is a detector of a metrology apparatus, wherein the method comprises determining the position related parameter of the detector relative to a substrate to be measured by the metrology apparatus based on:

the position related parameter of the detector relative to the optical element; and
a position of the optical element relative to the substrate.

17. A method according to any one of clauses 1 to 15, wherein the detector is a detector of a metrology apparatus, and wherein the optical element is disposed on a substrate to be measured by the metrology apparatus.

18. A method according to any one of the preceding clauses, wherein the optical element is configured such that at least one of the reference irradiance beams has an astigmatic profile; and
wherein the method comprises determining the position related parameter of the detector relative to the optical element based on a shape of the irradiance spot formed by the at least one reference irradiance beam having the astigmatic profile.

19. A method according to any one of the preceding clauses, wherein the optical element is configured such that two or more of the reference irradiance beams have different foci.

20. A method according to clause 19, comprising determining the position related parameter of the detector relative to the optical element based on sizes of the reference irradiance spots formed by the reference irradiance beams having different foci.

21. A method according to any one of the preceding clauses, wherein the reference irradiance pattern comprises a speckle pattern.

22. A method according to any one of the preceding clauses, comprising determining the position related parameter of the detector relative to the optical element based on positions of the reference irradiance spots on the detector.

23. A method according to any one of the preceding clauses, wherein the optical element comprises an alignment guide, and wherein the method comprises aligning the reference illumination with respect to the optical element based on radiation reflected by the alignment guide.

24. A method according to any one of the preceding clauses, wherein determining the position related parameter of the detector relative to the optical element based on the reference irradiance spots comprises fitting the position related parameter to positions of the reference irradiance spots on the detector.

25. A method according to any one of the preceding clauses, wherein determining the position related parameter of the detector relative to the optical element based on the reference irradiance spots comprises mapping positions of the reference irradiance spots on the detector to pupil coordinates of the reference irradiance beams.

26. A method according to any one of the preceding clauses, wherein the optical element is further configured such that the plurality of reference irradiance beams is incident on a second detector to form a second reference irradiance pattern on the second detector, the second reference irradiance pattern comprising a second plurality of reference irradiance spots; and
wherein the method further comprises determining a position related parameter of the second detector relative to the optical element based on the second plurality of reference irradiance spots.

27. A method according to any one of the preceding clauses, further comprising:

  illuminating a fiducial target with measurement illumination, wherein a spectrum of the measurement illumination comprises a plurality of spectral peaks, and wherein the fiducial target is configured to diffract the measurement illumination such that a diffraction pattern is incident on the detector;
  determining a position related parameter of the fiducial target relative to the detector based on the position related parameter of the detector relative to the optical element, and a position of the fiducial target relative to the optical element; and
  determining, from the diffraction pattern incident on the detector, wavelengths of the spectral peaks.

28. A method according to clause 27, wherein illuminating the fiducial target comprises rotating a mirror to direct the measurement illumination towards the fiducial target.

29. A method according to clause 27 or 28, further comprising obtaining a wavelength calibration for an illumination monitoring sensor using the determined wavelengths of the spectral peaks.

30. A method according to any one of clauses 27 to 29, further comprising:
determining, based on a diffraction efficiency spectrum of the fiducial target, an intensity spectrum for the measurement illumination.

31. A method according to clause 30, further comprising obtaining an intensity calibration for an illumination monitoring sensor using the determined intensity spectrum.

32. A method according to any one of clauses 27 to 31, wherein the fiducial target comprises a diffraction grating having a variable line spacing.

33. An apparatus comprising:

  a reference illumination source configured to illuminate an optical element with a reference illumination;
  a detector; and
  a processor;
  wherein the optical element is configured to produce, from the reference illumination, a plurality of reference irradiance beams incident on the detector to form a reference irradiance pattern on the detector, the reference irradiance pattern comprising a plurality of reference irradiance spots; and

wherein the processor is configured to determine a position related parameter of the detector relative to the optical element based on the plurality of reference irradiance spots.

34. An apparatus according to clause 33, wherein the reference irradiance pattern comprises at least three reference irradiance spots.

35. An apparatus according to clause 33 or 34, wherein the optical element comprises a phase mask.

36. An apparatus according to any one of clauses 33 to 35, wherein the optical element comprises an amplitude mask.

37. An apparatus according to any one of clauses 33 to 36, wherein the optical element comprises a grating.

38. An apparatus according to any one of clauses 33 to 37, wherein the optical element comprises a spatial light modulator.

39. An apparatus according to any one of clauses 33 to 38, wherein the optical element comprises a hologram.

40. An apparatus according to any one of clauses 33 to 39, wherein the optical element comprises a computer generated hologram.

41. An apparatus according to any one of clauses 33 to 40, wherein the optical element comprises a pinhole mask.

42. An apparatus according to any one of clauses 33 to 41, wherein the optical element comprises a plurality of parabolic mirrors.

43. An apparatus according to any one of clauses 33 to 42, wherein at least a portion of the optical element is reflective to the reference illumination.

44. An apparatus according to any one of clauses 33 to 43, wherein at least a portion of the optical element is transmissive to the reference illumination.

45. An apparatus according to any one of clauses 33 to 44, wherein the optical element comprises a photonic integrated circuit.

46. An apparatus according to any one of clauses 33 to 45, wherein the reference illumination source is configured to be aligned with respect to the optical element based on a reflection of the reference illumination by the optical element.

47. An apparatus according to any one of clauses 33 to 46, comprising an optical fiber configured to provide the reference illumination to the optical element.

48. An apparatus according any one of clauses 33 to 47, wherein the apparatus is a metrology apparatus, and wherein the processor is further configured to determine a position related parameter of the detector relative to a substrate to be measured by the metrology apparatus based on:

the position related parameter of the detector relative to the optical element; and

a position of the optical element relative to the substrate.

49. An apparatus according to any one of clauses 33 to 47, wherein the apparatus is a metrology apparatus, and wherein the optical element is disposed on a substrate to be measured by the metrology apparatus.

50. An apparatus according to any one of clauses 33 to 49, wherein the optical element is configured such that at least one of the reference irradiance beams has an astigmatic profile; and

wherein the processor is configured to determine the position related parameter of the detector relative to the optical element based on a shape of the irradiance spot formed by the reference irradiance beam having the astigmatic profile.

51. An apparatus according to any one of clauses 33 to 50, wherein the optical element is configured such that two or more of the reference irradiance beams have different foci.

52. An apparatus according to clause 51, wherein the processor is configured to determine the position related parameter of the detector relative to the optical element based on sizes of the reference irradiance spots formed by the reference irradiance beams having different foci.

53. An apparatus according to any one of clauses 33 to 52, wherein the optical element is configured such that the reference irradiance pattern comprises a speckle pattern.

54. An apparatus according to any one of clauses 33 to 53, wherein the processor is configured to determine the position related parameter of the detector relative to the optical element based on positions of the reference irradiance spots on the detector.

55. An apparatus according to any one of clauses 33 to 54, wherein the optical element comprises an alignment guide, and wherein the reference illumination source is configured to be aligned with respect to the optical element based on radiation reflected by the alignment guide.

56. An apparatus according to any one of clauses 33 to 55, wherein the processor is configured to determine the position related parameter of the detector relative to the optical element based on the reference irradiance spots by fitting the position related parameter to positions of the reference irradiance spots on the detector.

57. An apparatus according to any one of clauses 33 to 56, wherein the processor is configured to determine the position related parameter of the detector relative to the optical element by mapping positions of the reference irradiance spots on the detector to pupil coordinates of the reference irradiance beams.

57. An apparatus according to any one of clauses 33 to 57, further comprising a second detector, wherein the optical element is further configured such that the plurality of reference irradiance beams is incident on the second detector to form a second reference irradiance pattern, the second reference irradiance pattern comprising a second plurality of reference irradiance spots; and wherein the processor is further configured to determine the position related parameter of the second detector relative to the optical element based on the second plurality of reference irradiance spots.

59. An apparatus according to any one of clauses 33 to 58, further comprising a measurement illumination source configured to illuminate a fiducial target with a measurement illumination, a spectrum of the measurement illumination comprising a plurality of spectral peaks, wherein the fiducial target is configured to diffract the measurement illumination such that a diffraction pattern is incident on the detector; wherein the processor is further configured to:

determine a position related parameter of the fiducial target relative to the detector based on the position related parameter of the detector relative to the optical element, and position of the fiducial target relative to the optical element; and
determine, from the diffraction pattern incident on the detector, wavelengths of the spectral peaks.

60. An apparatus according to clause 59, further comprising a mirror, the mirror being rotatable to direct the measurement illumination towards the fiducial target.

61. An apparatus according to clause 59 or 60, further comprising an illumination monitoring sensor, wherein the processor is further configured to obtain a wavelength calibration for the illumination monitoring sensor using the determined wavelengths of the spectral peaks.

62. An apparatus according to any one of clauses 59 to 61, wherein the processor is further configured to determine, based on a diffraction efficiency spectrum of the fiducial target, an intensity spectrum for the measurement illumination.

63. An apparatus according to clause 62, wherein the processor is further configured to determine an intensity calibration for an illumination monitoring sensor using the determined intensity spectrum.

64. An apparatus according to any one of clauses 59 to 63, wherein the fiducial target comprises a diffraction grating having a variable line spacing.

65. A method comprising:

illuminating an optical element with a reference illumination, the optical element comprising a computer generated hologram, wherein the optical element is configured to produce, from the reference illumination, a plurality of reference irradiance beams incident on a detector to form a reference irradiance pattern on the detector, the reference irradiance pattern comprising a plurality of reference irradiance spots; and determining a position related parameter of the detector relative to the optical element based on the plurality of reference irradiance spots.

66. An apparatus comprising:

a reference illumination source configured to illuminate an optical element with a reference illumination, the optical element comprising a computer generated hologram;
a detector; and
a processor;
wherein the optical element is configured to produce, from the reference illumination, a plurality of reference irradiance beams incident on the detector to form a reference irradiance pattern on the detector, the reference irradiance pattern comprising a plurality of reference irradiance spots; and
wherein the processor is configured to determine a position related parameter of the detector relative to the optical element based on the plurality of reference irradiance spots.

67. A method comprising:

illuminating an optical element with a reference illumination, the optical element comprising a photonic integrated circuit configured to produce, from the reference illumination, a plurality of reference irradiance beams incident on a detector to form a reference irradiance pattern on the detector, the reference irradiance pattern comprising a plurality of reference irradiance spots; and
determining a position related parameter of the detector relative to the optical element based on the plurality of reference irradiance spots.

68. An apparatus comprising:

a reference illumination source configured to illuminate an optical element with a reference illumination, the optical element comprising a photonic integrated circuit;
a detector; and
a processor;
wherein the optical element is configured to produce, from the reference illumination, a plurality of reference irradiance beams incident on the detector to form a reference irradiance pattern on the detector, the reference irradiance pattern comprising a plurality of reference irradiance spots; and

wherein the processor is configured to determine a position related parameter of the detector relative to the optical element based on the plurality of reference irradiance spots.

69. A method comprising:

illuminating an optical element with a reference illumination, wherein the optical element is configured to produce, from the reference illumination, a plurality of reference irradiance beams incident on a detector to form a reference irradiance pattern on the detector, the reference irradiance pattern comprising a plurality of reference irradiance spots;
aligning the reference illumination with respect to the optical element based on a reflection of the reference illumination by the optical element; and
determining a position related parameter of the detector relative to the optical element based on the plurality of reference irradiance spots.

70. An apparatus comprising:

a reference illumination source configured to illuminate an optical element with a reference illumination, wherein the reference illumination source is configured to be aligned with respect to the optical element based on a reflection of the reference illumination by the optical element;
a detector; and
a processor;
wherein the optical element is configured to produce, from the reference illumination, a plurality of reference irradiance beams incident on the detector to form a reference irradiance pattern on the detector, the reference irradiance pattern comprising a plurality of reference irradiance spots; and
wherein the processor is configured to determine a position related parameter of the detector relative to the optical element based on the plurality of reference irradiance spots.

71. A method comprising:

illuminating an optical element with a reference illumination, wherein the optical element is configured to produce, from the reference illumination, a plurality of reference irradiance beams incident on a detector to form a reference irradiance pattern on the detector, at least one of the reference irradiance beams having an astigmatic profile, the reference irradiance pattern comprising a plurality of reference irradiance spots; and
determining a position related parameter of the detector relative to the optical element based on a shape of the irradiance spot formed by the reference irradiance beam having the astigmatic profile.

72. An apparatus comprising:

a reference illumination source configured to illuminate an optical element with a reference illumination;
a detector; and
a processor;
wherein the optical element is configured to produce, from the reference illumination, a plurality of reference irradiance beams incident on the detector to form a reference irradiance pattern on the detector, at least one of the reference irradiance beams having an astigmatic profile, the reference irradiance pattern comprising a plurality of reference irradiance spots; and
wherein the processor is configured to determine a position related parameter of the detector relative to the optical element based on a shape of the irradiance spot formed by the reference irradiance beam having the astigmatic profile.

73. A method comprising:

illuminating an optical element with a reference illumination, wherein the optical element is configured to produce, from the reference illumination, a plurality of reference irradiance beams incident on a detector to form a reference irradiance pattern on the detector, two or more of the reference irradiance beams having different foci, the reference irradiance pattern comprising a plurality of reference irradiance spots; and
determining a position related parameter of the detector relative to the optical element based on sizes of the reference irradiance spots formed by the reference irradiance beams having different foci.

74. An apparatus comprising:

a reference illumination source configured to illuminate an optical element with a reference illumination;
a detector; and
a processor;
wherein the optical element is configured to produce, from the reference illumination, a plurality of reference irradiance beams incident on the detector to form a reference irradiance pattern on the detector, two or more of the reference irradiance beams having different foci, the reference irradiance pattern comprising a plurality of reference irradiance spots; and
wherein the processor is configured to determine a position related parameter of the detector relative to the optical element based on sizes of the reference irradiance spots formed by the reference irradiance beams having different foci.

75. A computer program product comprising instructions which, when the program is executed by a computer, cause the computer to carry out a method according to any one of clauses 1 to 32, 65, 67, 69, 71, or 73.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

It should be appreciated that the term color is used throughout this text synonymously with wavelength or spectral component and the colors may include those outside the visible band (e.g., infrared or ultraviolet wavelengths).

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 1-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. An apparatus comprising:

   a reference illumination source configured to illuminate an optical element with a reference illumination;
   a detector; and
   a processor;
   wherein the optical element is configured to produce, from the reference illumination, a plurality of reference irradiance beams incident on the detector to form a reference irradiance pattern on the detector, the reference irradiance pattern comprising a plurality of reference irradiance spots; and
   wherein the processor is configured to determine a position related parameter of the detector relative to the optical element based on the plurality of reference irradiance spots.

2. An apparatus according to claim 1, wherein the reference irradiance pattern comprises at least three reference irradiance spots.

3. An apparatus according to claim 1 or 2, wherein the optical element comprises one or more of a phase mask, an amplitude mask, a grating, a spatial light modulator, a hologram, a computer generated hologram, a pinhole mask, and a plurality of parabolic mirrors.

4. An apparatus according to any one of claims 1 to 3, wherein at least a portion of the optical element is reflective to the reference illumination.

5. An apparatus according to any one of claims 1 to 4, wherein at least a portion of the optical element is transmissive to the reference illumination.

6. An apparatus according to any one of claims 1 to 5, wherein the optical element comprises a photonic integrated circuit.

7. An apparatus according to any one of claims 1 to 6, wherein the reference illumination source is configured to be aligned with respect to the optical element based on a reflection of the reference illumination by the optical element.

8. An apparatus according to any one of claims 1 to 7, comprising an optical fiber configured to provide the reference illumination to the optical element.

9. An apparatus according any one of claims 1 to 8, wherein the apparatus is a metrology apparatus, and wherein the processor is further configured to determine a position related parameter of the detector relative to a substrate to be measured by the metrology apparatus based on:

   the position related parameter of the detector relative to the optical element; and
   a position of the optical element relative to the substrate.

10. An apparatus according to any one of claims 1 to 8, wherein the apparatus is a metrology apparatus, and wherein the optical element is disposed on a substrate to be measured by the metrology apparatus.

11. An apparatus according to any one of claims 1 to 10, wherein the processor is configured to determine the position related parameter of the detector relative to the optical element based on positions of the reference irradiance spots on the detector.

12. An apparatus according to any one of claims 1 to 11, further comprising a second detector, wherein the optical element is further configured such that the plurality of reference irradiance beams is incident on the second detector to form a second reference irradiance pattern, the second reference irradiance pattern comprising a second plurality of reference irradiance spots; and
   wherein the processor is further configured to determine the position related parameter of the second detector relative to the optical element based on the second plurality of reference irradiance spots.

13. An apparatus according to any one of claims 1 to 12, further comprising a measurement illumination source configured to illuminate a fiducial target with a measurement illumination, a spectrum of the measurement illumination comprising a plurality of spectral peaks, wherein the fiducial target is configured to diffract the measurement illumination such that a diffraction pattern is incident on the detector;
   wherein the processor is further configured to:

   determine a position related parameter of the fiducial target relative to the detector based on the position related parameter of the detector relative to the optical element, and position of the fiducial target relative to the optical element; and
   determine, from the diffraction pattern incident on the detector, wavelengths of the spectral peaks.

14. A method comprising:

illuminating an optical element with a reference illumination, wherein the optical element is configured to produce, from the reference illumination, a plurality of reference irradiance beams incident on a detector to form a reference irradiance pattern on the detector, the reference irradiance pattern comprising a plurality of reference irradiance spots; and

determining a position related parameter of the detector relative to the optical element based on the plurality of reference irradiance spots.

15. A computer program product comprising instructions which, when the program is executed by a computer, cause the computer to carry out a method according to claim 14.

Fig. 1

Fig. 2

Fig. 3

Fig. 4

SM1

**Fig. 5**

**Fig. 6**

**Fig. 7**

**Fig. 8**

**Fig. 9**

**Fig. 10**

Fig. 11

Fig. 12

**Fig. 13**

**Fig. 14**

Fig. 15A

Fig. 15B

Fig. 16

Standard Astigmatic Astigmatic Astigmatic Defocused
beam S1 beam A1 beam A2 beam A3 beam D1

$\Delta z < 0$

$\Delta z = 0$

$\Delta z > 0$

$\uparrow y$
$\longrightarrow x$

## Fig. 17

Detector

A

B
$\uparrow y$
$\longrightarrow z$

C

D

## Fig. 18

Fig. 19

Fig. 20

2100

| S2102 | Illuminate an optical element with a reference illumination, wherein the optical element is configured to produce, from the reference illumination, a plurality of reference irradiance beams incident on a detector to form a reference irradiance pattern on the detector, the reference irradiance pattern comprising a plurality of reference irradiance spots. |

| S2104 | Determine a position related parameter of the detector relative to the optical element based on the plurality of reference irradiance spots. |

# Fig. 21

## EUROPEAN SEARCH REPORT

**Application Number**

EP 24 16 9424

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 341 213 A (GIROUX BRIAN W [US]) 23 August 1994 (1994-08-23) * abstract * * figures 1,9-14 * * column 1, lines 9-14 * * column 4, line 25 - column 10, line 6 * | 1-15 | INV. G03F7/00 H04N23/54 |
| X | EP 2 809 061 A1 (AXIS AB [SE]) 3 December 2014 (2014-12-03) * abstract * * figures 1,5,6 * * paragraphs [0001], [0059] - [0096] * | 1,14 | |
| X | DE 100 13 299 A1 (DEUTSCH ZENTR LUFT & RAUMFAHRT [DE]) 27 September 2001 (2001-09-27) * the whole document * | 1,14 | |

| | |
|---|---|
| | TECHNICAL FIELDS SEARCHED (IPC) |
| | G03F H04N |

The present search report has been drawn up for all claims

| Place of search | Date of completion of the search | Examiner |
|---|---|---|
| Munich | 13 November 2024 | Andersen, Ole |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 24 16 9424

This annex lists the patent family members relating to the patent documents cited in the above-mentioned European search report.
The members are as contained in the European Patent Office EDP file on
The European Patent Office is in no way liable for these particulars which are merely given for the purpose of information.

13-11-2024

| Patent document cited in search report | | Publication date | Patent family member(s) | Publication date |
|---|---|---|---|---|
| US 5341213 | A | 23-08-1994 | NONE | |
| EP 2809061 | A1 | 03-12-2014 | NONE | |
| DE 10013299 | A1 | 27-09-2001 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2006066855 A1
- US 2011102753 A1
- US 20120044470 A
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman et al/KLA
- US 20170184981 A1
- US 2016282282 A1

### Non-patent literature cited in the description

- **LEMAILLET et al.** Intercomparison between optical and X-ray scatterometry measurements of FinFET structures. *Proc. of SPIE*, 2013, 8681